# EUROPEAN PATENT APPLICATION

(11) **EP 3 157 041 A1**
(43) Date of publication of application: **19.04.2017**
(21) Application number: 15189500.0
(22) Date of filing: 13.10.2015
(51) Int. Cl.: H01J 37/244, G01T 1/20

(54) **INVESTIGATION OF HIGH-TEMPERATURE SPECIMENS IN A CHARGED PARTICLE MICROSCOPE**

(71) Applicant: FEI Company, Hillsboro, OR 97124-5793 (US)
(72) Inventor: Novak, Libor, 64100 Brno (CZ); Hlavenka, Petr, 61600 Brno (CZ); Uncovsky, Marek, 613 00 BRNO (CZ); Cafourek, Martin, 67401 Trebic (CZ)
(74) Representative: Bakker, Hendrik

(57) **Abstract**

A method of examining a specimen in a Charged Particle Microscope, comprising the following steps:
- Providing a specimen on a specimen holder;
- Heating the specimen to a temperature of at least 250°C;
- Directing a beam of charged particles from a source through an illuminator so as to irradiate the specimen;
- Using a detector to detect a flux of electrons emanating from the specimen in response to said irradiation,

wherein said detector comprises:
- A scintillator module, which produces photons in response to impingement by electrons in said flux;
- A photon sensor, for sensing said photons,

and is configured to:
- Preferentially register a first category of photons, associated with impingement of electrons on said scintillator module;
- Selectively suppress a second category of photons, comprising thermal radiation from the heated specimen.

## Description

The invention relates to a method of examining a specimen in a Charged Particle Microscope, comprising the following steps:
- Providing a specimen on a specimen holder;
- Heating the specimen to a temperature of at least 250°C;
- Directing a beam of charged particles from a source through an illuminator so as to irradiate the specimen;
- Using a detector to detect a flux of electrons emanating from the specimen in response to said irradiation

The invention also relates to a Charged Particle Microscope in which such a method can be enacted.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" Focused Ion Beam (FIB), allowing supportive activities such as ion-beam milling or Ion-Beam-Induced Deposition (IBID), for example. More specifically:
- In a SEM, irradiation of a specimen by a scanning electron beam precipitates emanation of "auxiliary" radiation from the specimen, in the form of secondary electrons, backscattered electrons, X-rays and photoluminescence (infrared, visible and/or ultraviolet photons), for example; one or more components of this flux of emanating radiation is/are then detected and used for image accumulation purposes.
- In a TEM, the electron beam used to irradiate the specimen is chosen to be of a high-enough energy to penetrate the specimen (which, to this end, will generally be thinner than in the case of a SEM specimen); the flux of transmitted electrons emanating from the specimen can then be used to create an image. When such a TEM is operated in scanning mode (thus becoming a STEM), the image in question will be accumulated during a scanning motion of the irradiating electron beam.

More information on some of the topics elucidated here can, for example, be gleaned from the following Wikipedia links:
http://en.wikipedia.org/wiki/Electron microscope
http://en.wikipedia.org/wiki/Scanning electron microscope
http://en.wikipedia.org/wiki/Transmission electron microscopy
http://en.wikipedia.org/wiki/Scanning transmission electron microscopy

As an alternative to the use of electrons as irradiating beam, charged particle microscopy can also be performed using other species of charged particle. In this respect, the phrase "charged particle" should be broadly interpreted as encompassing electrons, positive ions (e.g. Ga or He ions), negative ions, protons and positrons, for instance. As regards non-electron-based charged particle microscopy, some further information can, for example, be gleaned from sources such as the following:
https://en.wikipedia.org/wiki/Focused ion beam
http://en.wikipedia.org/wiki/Scanning Helium Ion Microscope - W.H. Escovitz, T.R. Fox and R. Levi-Setti, Scanning Transmission Ion Microscope with a Field Ion Source, Proc. Nat. Acad. Sci. USA 72(5), pp 1826-1828 (1975).
http://www.ncbi.nlm.nih.gov/pubmed/22472444
It should be noted that, in addition to imaging and performing (localized) surface modification (e.g. milling, etching, deposition, etc.), a charged particle microscope may also have other functionalities, such as performing spectroscopy, examining diffractograms, etc.

In all cases, a Charged Particle Microscope (CPM) will comprise at least the following components:
- A radiation source, such as a Schottky electron source or ion gun.
- An illuminator, which serves to manipulate a "raw" radiation beam from the source and perform upon it certain operations such as focusing, aberration mitigation, cropping (with an aperture), filtering, etc. It will generally comprise one or more (charged-particle) lenses, and may comprise other types of (particle-)optical component also. If desired, the illuminator can be provided with a deflector system that can be invoked to cause its output beam to perform a scanning motion across the specimen being investigated.
- A specimen holder, on which a specimen under investigation can be held and positioned (e.g. tilted, rotated). If desired, this holder can be moved so as to effect the desired scanning motion of the beam w.r.t. the specimen. In general, such a specimen holder will be connected to a positioning system such as a mechanical stage.
- A detector (for detecting radiation emanating from an irradiated specimen), which may be unitary or compound/distributed in nature, and which can take many different forms, depending on the radiation being detected. Examples include photodiodes, CMOS detectors, CCD detectors, photovoltaic cells, X-ray detectors (such as Silicon Drift Detectors and Si(Li) detectors), etc. In general, a CPM may comprise several different types of detector, selections of which can be invoked in different situations.
In the particular case of a scanning-type apparatus (such as a SEM, for example), the CPM will comprise:
- Scanning means, for producing relative scanning motion of the radiation beam and the specimen, thereby causing the beam to trace out a pre-determined (two-dimensional) scan pattern on (a presented surface of) the specimen. An image is then constructed on the basis of detector output per sampling point on the scan pattern, thus constructing a (two-dimensional) map of said specimen (surface). As alluded to above, such scanning means may, for example, be based on beam (scanning) deflection or holder (scanning) motion.
In the specific context of the present invention, the CPM will further comprise: - Heating means, for heating the specimen to an elevated temperature, e.g. in the (non-limiting) range 250-3000 °C. Such heating means may, for example, comprise a (MEMS) resistive element heater, laser beam heater, or a heater based on (dedicated) electron/ion beam bombardment, for instance, which can be invoked when there is a desire to perform high-temperature microscopic studies on the specimen, e.g. as part of a broader study of temperature-dependent processes in the specimen, such as crystalline and/or phase transitions, grain structure changes in metals, impurity migration, desiccation behavior, etc. In combination with (precursor) gas injection into the specimen vicinity, one can also study heat-induced chemical processes (e.g. CVD), which can, for instance, be useful when investigating nanowire growth, analyzing surface oxidation, etc.
In what follows, the invention may - by way of example - sometimes be set forth in the specific context of electron microscopy. However, such simplification is intended solely for clarity/illustrative purposes, and should not be interpreted as limiting.

Methods as alluded to in the opening paragraph above are often performed in a SEM or STEM, for instance, in which a relatively narrow charged-particle beam (sometimes called a "probe") is scanned over a presented surface of the specimen, and the employed detector constructs a pixel-by-pixel image of said surface (on the basis of detector output as a function of coordinate position on the surface). Because space around the specimen holder within a CPM is typically very cramped, employed detectors are preferably as compact as possible and, in this regard, modern CPMs tend to make use of (integrated) solid state detectors where feasible. These not only have the advantage of being relatively small and cheap, but they also have relatively fast response times, for example. However, when used to detect electrons emanating from an irradiated high-temperature specimen, such detectors begin to demonstrate a much worse signal-to-noise ratio (SNR) than when used with lower-temperature specimens. The conventional way to improve SNR in such cases is to increase the primary beam current - which, however, tends to have a detrimental effect on attainable imaging resolution.

Although scenarios such as that set forth in the previous paragraph have produced tolerable results up to now, the current inventors have worked extensively to substantially improve such conventional approaches. The results of this endeavor are the subject of the current invention.

It is an object of the invention to provide an improved method of examining high-temperature specimens in a charged particle microscope as referred to above. In particular, it is an object of the invention that such a method (and the associated microscope) should employ an alternative detection strategy to the high-specimen-temperature approaches known from the prior art. More specifically, it is an object of the invention that the innovative method/microscope should allow an improved SNR/resolution tradeoff as compared to the prior art.

These and other objects are achieved in a method as set forth in the opening paragraph above, characterized in that said detector comprises:
- A scintillator module, which produces photons in response to impingement by electrons in said flux;
- A photon sensor, for sensing said photons,
and is configured to:
- Preferentially register a first category of photons, associated with impingement of electrons on said scintillator module;
- Selectively suppress a second category of photons, comprising thermal radiation from the heated specimen.

The invention exploits the insight that modern solid state detectors used for electron detection in CPMs are also sensitive to photonic radiation. Nominally, this is not an issue, since the "background" level of photonic radiation in a CPM is generally relatively low compared to typical fluxes of electrons emanating from a specimen. However, an exception arises when a specimen is heated to relatively high temperatures, since such a specimen will begin to strongly emit (infra-red) photons, which tend to overwhelm the detector. The problem is therefore how to "weed out" such unwanted thermal photons from the electron flux striking the detector - and thereby obviate the need to increase primary beam current (in an attempt to produce a stronger electron flux at the detector relative to the elevated thermal photon intensity). Theoretically, one could do this by using a deflecting field to deflect electrons out of the mixed photon/electron stream emanating from the sample, and then collect these electrons at a screened location; however, such an approach would be practically difficult to achieve, since it would be bulky / space-consuming, and would also potentially introduce stray fields to the vicinity of the particle-optical column. Instead, the current invention takes a somewhat counter-intuitive approach, in that it uses a detector that comprises a paired scintillator plate (module) and electron sensor, the scintillator plate serving to convert the electron flux from the specimen into a photon flux. Thermal photons can also traverse the scintillator plate, thus confronting the sensor with two different categories of photons. Since these two radiation categories are now homogeneous (both photonic) instead of heterogeneous (one electronic, one photonic), it becomes possible to separate them efficiently; see, in this regard, the examples given below.

The electron sensor in the inventive detector may, for example, comprise an evacuated (vitreous) Photo-Multiplier Tube (PMT), or an SSPM (also referred to as a MultiPixel Photon Counter [MPPC]), for instance. The scintillator module may, for example, comprise a YAP (Yttrium Aluminium Perovskite) or YAG (Yttrium Aluminium Garnet) crystal, for instance, or it can comprise another material, such as CsF, BaF₂, CaF₂ (Eu), CdWO₄, etc.; in many cases, it may be embodied as a powder film (e.g. P47 phosphor powder) that is bonded to a transparent substrate. For scanning applications (e.g. in a SEM, FIB, etc.), use is typically made of a scintillator with a decay time less than about 100ns. If desired, the scintillator module and associated electron sensor may be coupled to one another *via* a light guide (or collection of light guides). It should be noted that each of the scintillator module and the electron sensor may be unitary or compound in nature, as desired/required in a particular set-up.

According to the invention, there are various ways in which the detector can be configured to perform the desired selective photon registration/suppression. In a particular embodiment, the detector comprises a color filter between its scintillator module and photon sensor, which filter preferentially passes photons in said first category but selectively attenuates photons in said second category. Such behavior may be achieved using different mechanisms, such as:
- Selectively absorbing photons in the second category;
- Using selective interference affects to reflect back (reject) photons in the second category, as in the case of a dielectric optical filter;
- Selectively dispersing photons in the second category, using a dispersive optical element such as a grating or prism, for instance.
The employed filter may take various forms, and can comprise, for example, a sheet of suitably dyed glass or plastic, or a thinly metallized dielectric plate, for instance. Alternatively/supplementally, it may comprise an optical element that is made from a carefully selected material. For example:
- Common glass will attenuate/absorb a wide range of infra-red (IR) and ultra-violet (UV) wavelengths, while transmitting visible wavelengths;
- A thin sheet of water captured between two glass plates will block a wide range of IR wavelengths.
Examples of dyes that are often used for absorbing near-IR light (for instance) include substances such as Phthalocyanine, Squarylium, Diimonium, Cyanine, and certain Dithiolene complexes, which may be dispersed in a polymer matrix and extruded into sheet form, if desired. Other categories of filter include, for example:
- Dichroic hot/cold mirrors;
- Liquid Crystal tunable filters.
Of particular importance in the current invention (where thermal photons are to be attenuated) are:
- IR cut-off filters;
- UV / visible light bandpass filters.
The skilled artisan will be well able to select a filter according to the parameters/demands of a particular detection scenario.

In a refinement of the embodiment set forth in the previous paragraph, the employed filter comprises a series stack of component sub-filters. Such an embodiment can, for example, be particularly useful when one is attempting to simultaneously suppress two different wavelength ranges, e.g. to create a bandpass filter, or a more efficient/thorough cutoff filter.

In another embodiment of the invention, the employed photon sensor is configured to produce a relatively strong detection signal in response to photons in said first category but produce a relatively weak detection signal in response to photons in said second category. In this case, as opposed to attempting to pre-filter the spectrum of photons that reach the photon sensor, one instead embodies the photon sensor to have a (wavelength-)selective response to the photons impinging on it. One way to achieve this is to:
- Embody the photon sensor as a photomultiplier, which comprises a photocathode;
- Tailor the photocathode to have a sensitivity curve with a relatively high value for photons
   in said first category and a relatively low value for photons in said second category.
Such an embodiment effectively tailors the quantum efficiency (QE) (or spectral responsivity) of the material of the photocathode so as to produce a response curve with a given form. Such tailoring can, for example, be achieved by adjusting a degree/nature of doping of the photocathode material; for example, doping with indium can be used to produce a relative redshift in QE. Other dopants that can be used in this regard include iodine, bromine and erbium, for example.

If desired, one can, of course, embody the inventive detector to combine both of the approaches set forth above, *i.e.* selective pre-filtering + selective sensor response.

As rule of thumb, if the inventive detector uses a scintillator with a maximum emission wavelength (in response to electron impingement) of λₑ, then one can elect to define the second-category photons of the present invention as being those with wavelengths longer than *K*λₑ, where K is a tuning factor with *K* ≥ 1. So, in the (non-limiting) example of a YAP scintillator with λₑ ∼ 350nm, for instance, the current invention could be used to suppress photons with a wavelength longer than 350 nm (K =1), or longer than 365 nm (K ∼ 1.04), or longer than 600 nm (K ∼ 1.7), etc.

The invention will now be elucidated in more detail on the basis of exemplary embodiments and the accompanying schematic drawings, in which:
Figure 1 renders a cross-sectional view of an embodiment of a (scanning-type) charged particle microscope in which the present invention can be implemented.
Figure 2A depicts an embodiment of a detector suitable for use in the current invention.
Figure 2B renders an exploded view of the subject of Figure 2A, and illustrates its operating principle.
Figure 3 illustrates a different embodiment of a detector suitable for use in the present invention.

In the Figures, where pertinent, corresponding parts may be indicated using corresponding reference symbols.

### Embodiment 1

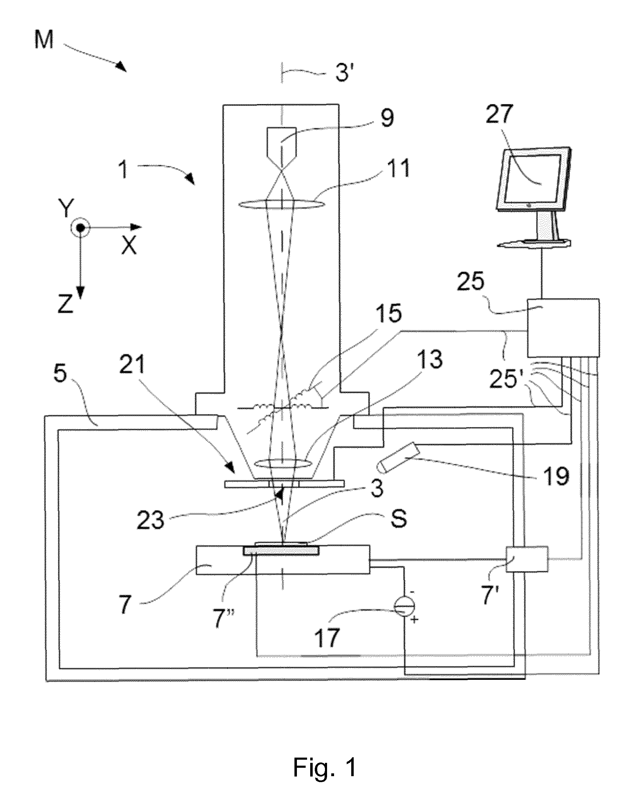

Figure 1 is a highly schematic depiction of an embodiment of a CPM in which the present invention can be implemented; more specifically, it shows an embodiment of a scanning-type microscope M, which, in this case, is a SEM (though, in the context of the current invention, it could just as validly be an ion-based microscope, for example). The microscope M comprises a particle-optical column / illuminator 1, which produces a beam 3 of input charged particles (in this case, an electron beam) that propagates along a particle-optical axis 3'. The particle-optical column 1 is mounted on a vacuum chamber 5, which comprises a specimen holder 7 and associated stage/actuator 7' for holding/positioning a specimen S. The vacuum chamber 5 is evacuated using vacuum pumps (not depicted). With the aid of voltage source 17, the specimen holder 7, or at least the specimen S, may, if desired, be biased (floated) to an electrical potential with respect to ground.

The particle-optical column 1 comprises an electron source 9 (such as a Schottky gun, for example), lenses 11, 13 to focus the electron beam 3 onto the specimen S, and a deflection unit 15 (to perform beam steering / scanning of the beam 3). The apparatus M further comprises a controller / computer processing apparatus 25 for controlling *inter alia* the deflection unit 15, lenses 11,13 and detectors 19, 21, and displaying information gathered from the detectors 19, 21 on a display unit 27.

The detectors 19, 21 are chosen from a variety of possible detector types that can be used to examine different types of output radiation flux emanating from the specimen S in response to irradiation by the input beam 3. In the apparatus depicted here, the following (non-limiting) detector choices have been made:
- Detector 19 is a solid state detector (such as a photodiode) that is used to detect (at least a portion of) an output flux of secondary electrons emanating from the specimen S;
- Detector 21 is a segmented silicon electron detector, comprising a plurality of independent detection segments (e.g. quadrants) disposed about a central aperture 23 (allowing passage of the beam 3). Such a detector can, for example, be used to investigate the angular dependence of a flux of output (secondary or backscattered) electrons emerging from the specimen S.
As here rendered, both detectors 19 and 21 are used to examine electrons; however, this is purely a design/implementation choice and, if desired, one could also elect to detect other types of output radiation flux emanating from the specimen S (e.g. X-rays, cathodoluminescence) in addition, or as an alternative, to electrons.

By scanning the input beam 3 over the specimen S, output radiation - comprising, for example, a flux of X-rays, infrared/visible/ultraviolet light, secondary electrons and/or backscattered (BS) electrons - emanates from the specimen S. Since such output radiation is position-sensitive (due to said scanning motion), the information obtained from the detectors 19, 21 will also be position-dependent. This fact allows the output of detector 19 (for instance) to be used to produce (for example) a secondary electron image of (part of) the specimen S, which image is basically a map of an output of detector 19 as a function of scan-path position on the specimen S.

The signals from the detectors 19, 21 pass along control lines (buses) 25', are processed by the controller 25, and displayed on display unit 27. Such processing may include operations such as combining, integrating, subtracting, false colouring, edge enhancing, and other processing known to the skilled artisan. In addition, automated recognition processes (e.g. as used for particle analysis) may be included in such processing.

It should be noted that many refinements and alternatives of such a set-up will be known to the skilled artisan, including, but not limited to:
- The use of dual beams - for example an electron beam 3 for imaging and an ion beam for machining (or, in some cases, imaging) the specimen S;
- The use of a controlled environment at the specimen S - for example, maintaining a pressure of several mbar (as used in a so-called Environmental SEM) or by admitting gases, such as etching or precursor gases,
etc. Although the scanning-type microscope shown in Figure 1 is a SEM, it could, in the context of the current invention, just as validly be a STEM, for example; in that case, a further particle-optical column (projection system; not depicted) will be located below the specimen S, to capture radiation transmitted through the specimen S during scanning and direct it onto a STEM detector (not depicted).

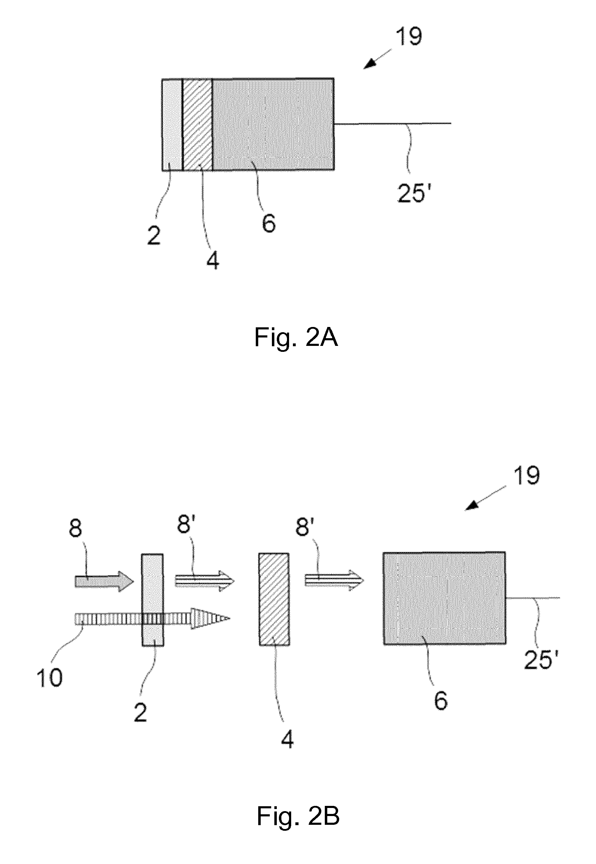

In the specific context of the current invention, the following items will now be discussed:
- Item 7" is a heating module (heating means) that can be used to heat the specimen S to an elevated temperature, e.g. in the range 200-2000°C. It may, for example, be a resistive element (e.g. a MEMS bi-fibrillar (magnetic-field-cancelling) heating element) incorporated into the top of the specimen holder 7, whereby the temperature of the specimen will depend on the electrical current sent through the element. Alternatively, one might use a laser beam (not depicted) to heat the specimen S, whereby specimen temperature could be adjusted by adjusting the power (or pulse frequency, or scan speed) of the laser, for example.
- So as to be able to execute the present invention, detector 19 is modified (see Figures 2A, 2B) to comprise a series connection of:
   ▪ A scintillator module 2, which produces signal photons 8' in response to impingement by electrons 8 emanating from specimen S;
   ▪ A photon sensor 6, for sensing said photons 8' (but which can also detect other photonic radiation).
As depicted (in longitudinal cross-section) in Figures 2A, 2B, a color filter (wavelength-selective filter) 4 has been sandwiched between items 2 and 6. Also depicted in Figure 2B is a stream of photons 10 comprising thermal photons from heated specimen S (and, potentially, also from (heated parts of) the specimen holder 7). This stream 10 passes (substantially unimpeded, though generally with some attenuation, due to absorption/refraction) through scintillator module 2 in the direction of sensor 6, in which the unwanted photons 10 would tend to overwhelm the contribution from signal photons 8' if left unimpeded. To prevent this, filter 4 is employed, which is tailored so as to pass/transmit (the particular wavelength(s) associated with) signal photons 8' but attenuate/block (the particular wavelength(s) associated with) unwanted photons 10. The wavelength(s) associated with signal photons 8' can be influenced by suitable choice of the material(s) in scintillator module 2. The photon sensor 6 may, for example, be a PMT or SSPM.

### Embodiment 2

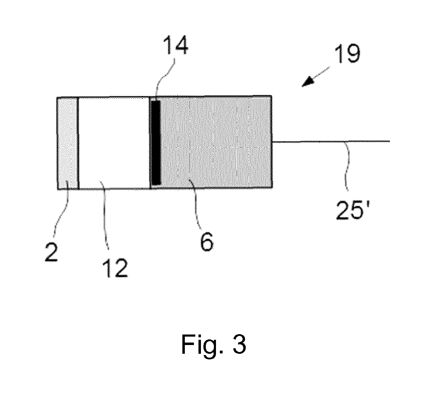

Figure 3 illustrates a (longitudinal cross-section of a) different embodiment of a detector 19 suitable for use in the present invention. In this embodiment, the filter 4 of Embodiment 2 has been omitted (although this does not have to be the case). Optionally, an optical waveguide 12 is interposed between the scintillator module 2 and electron sensor 6 (again, this does not have to be the case). In accordance with the invention, sensor 6 is chosen to be a photomultiplier with a photocathode 14, and this photocathode 14 comprises material that has been selected/tailored so as to demonstrate a sensitivity curve with a relatively high value for photons in said first category and a relatively low value for photons in said second category. With reference to Figure 2B, what this effectively means is that both the signal photons 8' and the thermal photons 10 will reach and impact the photocathode 14, but that only the signal photons 8' will cause significant photoelectric emission from the photocathode 14. This is because the Quantum Efficiency of the photocathode 14 is tuned to be relatively high for the wavelength(s) associated with the signal photons 8', but relatively low (or substantially zero) for the wavelength(s) associated with the photon stream 10.

## Claims

1. A method of examining a specimen in a Charged Particle Microscope, comprising the following steps:
- Providing a specimen on a specimen holder;
- Heating the specimen to a temperature of at least 250°C;
- Directing a beam of charged particles from a source through an illuminator so as to irradiate the specimen;
- Using a detector to detect a flux of electrons emanating from the specimen in response to said irradiation,
**characterized in that** said detector comprises:
- A scintillator module, which produces photons in response to impingement by electrons in said flux;
- A photon sensor, for sensing said photons,
and is configured to:
- Preferentially register a first category of photons, associated with impingement of electrons on said scintillator module;
- Selectively suppress a second category of photons, comprising thermal radiation from the heated specimen.

2. A method according to claim 1, wherein said detector comprises a color filter between said scintillator module and said photon sensor, which filter preferentially passes photons in said first category but selectively attenuates photons in said second category.

3. A method according to claim 2, wherein said filter comprises a series stack of component sub-filters.

4. A method according to any of claims 1-3, wherein said photon sensor is configured to produce a relatively strong detection signal in response to photons in said first category but produce a relatively weak detection signal in response to photons in said second category.

5. A method according to claim 4, wherein:
- Said photon sensor is a photomultiplier, which comprises a photocathode;
- Said photocathode has a sensitivity curve with a relatively high value for photons in said first category and a relatively low value for photons in said second category.

6. A method according to any of claims 1-5, wherein a light guide is disposed between said scintillator module and said photon sensor.

7. A scanning-type Charged Particle Microscope, comprising:
- A specimen holder, for holding a specimen;
- Heating means, for heating the specimen to a temperature of at least 250°C;
- A source, for producing a beam of charged particles;
- An illuminator, for directing said beam so as to irradiate the specimen;
- A detector, for detecting a flux of radiation emanating from the specimen in response to said irradiation,
**characterized in that** said detector comprises:
- A scintillator module, which produces photons in response to impingement by electrons in said flux;
- A photon sensor, for sensing said photons,
and is configured to:
- Preferentially register a first category of photons, associated with impingement of electrons on said scintillator module;
- Selectively suppress a second category of photons, comprising thermal radiation from the heated specimen.
